(19) Europäisches Patentamt
European Patent Office
Office européen des brevets

(11) **EP 4 585 946 A1**

(12) **EUROPEAN PATENT APPLICATION**
published in accordance with Art. 153(4) EPC

(43) Date of publication:
**16.07.2025 Bulletin 2025/29**

(51) International Patent Classification (IPC):
*G01R 31/3828* (2019.01)    *G01R 31/396* (2019.01)
*G01R 31/367* (2019.01)    *G01R 31/385* (2019.01)
*G01R 31/374* (2019.01)    *G01R 19/165* (2006.01)
*G01R 35/00* (2006.01)    *H02J 7/00* (2006.01)

(21) Application number: **24826106.7**

(22) Date of filing: **24.04.2024**

(52) Cooperative Patent Classification (CPC):
**G01R 31/3842; G01R 31/367; G01R 31/3828;
G01R 31/396; G01R 35/005;** Y02E 60/10

(86) International application number:
**PCT/KR2024/005490**

(87) International publication number:
**WO 2024/262783 (26.12.2024 Gazette 2024/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **20.06.2023 KR 20230079004**

(71) Applicant: **LG Energy Solution, Ltd.
Seoul 07335 (KR)**

(72) Inventor: **YUN, Seongjun
Daejeon 34122 (KR)**

(74) Representative: **Plasseraud IP
104 Rue de Richelieu
CS92104
75080 Paris Cedex 02 (FR)**

(54) **CALIBRATION METHOD FOR STATE OF CHARGE, AND BATTERY SYSTEM PROVIDING SAME**

(57) A battery system includes: a storage that stores, at each predetermined storage period, mapping data that map an SOC and a first open voltage; and a controller that performs: when a number of times of storing the mapping data reaches a predetermined reference number of times so that a calibration period arrives, estimating a first relationship graph between a plurality of SOCs and a plurality of open circuit voltages; calculating a plurality of relationship graphs by reflecting a plurality of preset error values in the first relationship graph; calculating a summed value of distances between each of the plurality of relationship graphs and the mapping data; determining an error value corresponding to a minimum value among a plurality of summed values to be a final error value; and determining whether the final error value falls within a predetermined reference range, to determine whether to calibrate an initial SOC value.

*FIG. 2*

EP 4 585 946 A1

**Description**

[Technical Field]

CROSS-REFERENCE TO RELATED APPLICATIONS

This application is based on and claims priority from Korean Patent Application No. 10-2023-0079004, filed on June 20, 2023 with the Korean Intellectual Property Office, the disclosure of which is incorporated herein in its entirety by reference.

The present disclosure relates to a method for calibrating an initial value of a state of charge (SOC) and a battery system for providing the method.

[Background Art]

The state of charge (SOC) of a battery may represent a relative amount of energy stored in the battery. For example, the SOC may be expressed as a percentage (%) resulting from dividing the current capacity of a battery by the total capacity of the battery.

The SOC is a crucial element for managing a system that operates with the battery power. Thus, the accurate measurement of SOC may be used as an indicator of the core competitiveness of battery manufacturers.

There are various methods to estimate the SOC of a battery, including a voltage-SOC estimation method *(e.g., the open-circuit voltage method)* and a current integration method *(e.g., the Coulomb counting method)*. The voltage-SOC estimation method may estimate the SOC by measuring an open circuit voltage (OCV) of a battery, and comparing the measured OCV with an SOC-OCV relationship graph. The current integration method, which is also called the Coulomb counting method, may estimate the SOC by adding or subtracting an integral value of current during the charge or discharge cycle to/from an initial SOC value.

The voltage-SOC estimation method is a simple method that estimates the SOC by measuring only the voltage of a battery, but has a drawback in that it is difficult to estimate the SOC in real time because the current charged or discharged in the battery remains in the battery even after being cut off (open), which requires a pause time for the accurate estimation.

Further, in a battery made of lithium iron phosphate (Li-FePO$_4$), the OCV tends to maintain the plateau state. That is, there is a difficulty in accurately estimating the SOC of the battery made of lithium iron phosphate (Li-FePO$_4$) from the OCV. That is, due to various causes, the SOC of a battery made of, for example, lithium iron phosphate (Li-FePO$_4$) may be estimated only by the current integration method, rather than the voltage-SOC estimation method.

The current integration method is a common method that may estimate the SCO in real time, but is disadvantageous in that an accurate initial value may not be obtained at the beginning of the estimation, or measurement errors of a current sensor that measures the battery current and errors occurring during the analog-to-digital conversion (ADC) may be accumulated continuously during the estimation. For example, since the SOC estimation in the current integration method relies on the initial SOC value, errors may occur in the SOC estimation when the initial value is not accurate, and further, the accuracy of the SOC estimation may decrease when the errors are accumulated as the runtime of a battery increases.

In order to resolve the problems above, an operator may transmit a full charge control signal to a battery management system (BMS), for example, at intervals of estimated time period during which the errors have been accumulated (*e.g.*, about two weeks). Then, the battery management system (BMS) charges the battery, and when the SOC of the battery reaches the full charged state (100 %), the initial value of the SOC is reset to 100 % so that the SOC is calibrated. That is, the SOC estimation method using the current integration method requires the cumbersome process of fully charging the battery at periodic intervals in order to calibrate the initial SOC value.

[Disclosure]

[Technical Problem]

The present disclosure attempts to provide an SOC calibration method, which calibrates an initial SOC value of a battery based on accumulated data even without fully charging the battery, and a battery system for providing the method.

[Technical Solution]

According to an embodiment of the present disclosure, a battery system for estimating a state of charge (SOC) of a battery cell includes: a storage that stores, at each predetermined storage period, mapping data that map an SOC of the battery cell estimated based on an integral value of a cell current flowing in the battery cell, and a first open voltage estimated through a predetermined model that simulates a cell voltage corresponding to the cell current; and a controller that performs a process including: when a number of times of storing the mapping data reaches a predetermined reference number of times so that a calibration period arrives, estimating a first relationship graph, which is a graph of a relationship between a plurality of SOCs and a plurality of open circuit voltages stored in the storage, based on a predetermined SOC-open circuit voltage lookup table; calculating a plurality of relationship graphs by reflecting a plurality of preset error values in the first relationship graph; calculating a summed value of distances between each of the plurality of relationship graphs and the mapping data; determining an error value corresponding to a minimum value among a plurality of summed values to be a final error value between the first open voltage and a second open voltage; and determining whether the final error value falls within a predetermined reference range, to determine whether to calibrate an initial SOC value.

According to another embodiment of the present disclosure, a battery system for estimating a state of charge of a battery cell includes: a storage that stores, at each predetermined storage period, mapping data that map a state of charge (SOC) estimated based on an integral value of a cell current flowing in a battery cell, and a first open voltage estimated through a predetermined model that simulates a cell voltage corresponding to the cell current; and a controller that performs a process including: when a number of times of storing the mapping data reaches a predetermined reference number of times so that a calibration period arrives, estimating a plurality of second open voltages corresponding to a plurality of SOCs stored in the storage based on a predetermined SOC-open circuit voltage lookup table; calculating a final error value corresponding to a degree of discrepancy between a plurality of first open voltages stored in the storage and the plurality of second open voltages based on a predetermined cost function that quantifies a degree of matching between the plurality of first open voltages and the plurality of second open voltages; and determining whether the final error value falls within a predetermined reference range, to determine whether to calibrate an initial SOC value.

According to yet another embodiment of the present disclosure, a method of calibrating a state of charge includes: when a predetermined storage period arrives, estimating a state of charge (SOC) of a battery cell and a first open voltage based on an integral value of a cell current flowing in the battery cell and a predetermined model that simulates a cell voltage corresponding to the cell current, respectively; storing mapping data that map the SOC and the first open voltage in a storage; when a number of times of storing the mapping data reaches a predetermined reference number of times so that a calibration period arrives, estimating a plurality of second open voltages corresponding to a plurality of SOCs stored in the storage based on a predetermined SOC-open circuit voltage lookup table; calculating a final error value corresponding to a degree of discrepancy between a plurality of first open voltages stored in the storage and the plurality of second open voltages based on a predetermined cost function that quantifies a degree of matching between the plurality of first open voltages and the plurality of second open voltages; determining whether the final error value falls within a predetermined reference range; and when determined that the final error value is out of the predetermined reference range, calibrating an initial SOC value.

[Advantageous Effects]

The present disclosure may calibrate an error of the SOC estimated by current integration method, by using a simple method even without fully charging a battery (100 %).

[Description of the Drawings]

FIG. 1 is a block diagram illustrating a battery system according to an embodiment of the present disclosure.

FIG. 2 is a conceptual diagram illustrating a plurality of estimation modules and a mapping table stored in a storage unit of FIG. 1.

FIGS. 3 to 7 are graphs illustrating a method of estimating a first open voltage according to an embodiment.

FIG. 8 is a view illustrating an example representing whether the first open voltage and a second open voltage match, according to an embodiment.

FIG. 9 is a view illustrating another example representing whether the first open voltage and the second open voltage match, according to an embodiment.

FIG. 10 is a flow chart illustrating a method of calibrating a state of charge (SOC) according to an embodiment.

[Mode for Invention]

Hereinafter, embodiments of the present disclosure will be described in detail with reference to the accompanying drawings. The same or similar components will be denoted with the same or similar reference numerals, and overlapping descriptions thereof will be omitted. The terms "module" and/or "unit" may be added or used together at the end of a name of a component exclusively to facilitate the description of the present disclosure, and the terms themselves do not have their distinct meanings or roles. When describing embodiments of the present disclosure, detailed description of related known art may be omitted if determined to obscure the gist of the embodiments. Further, the accompanying drawings are intended merely to facilitate the understanding of embodiments described herein without limiting the technical idea of the present disclosure, and should be construed as encompassing all modifications, equivalents, and substitutes included in the technical gist and scope of the present disclosure.

Terms with ordinal numbers such as first, second and so on may be used to describe various components, but should not be interpreted as limiting the components. The terms are used solely for the purpose of discriminating a component from others.

When two components are "coupled" or "connected" to each other, this description should be understood to indicate not only that the two components are directly coupled or connected to each other, but also that another component may be present between the two components. Meanwhile, when two components are "directly coupled" or "directly connected" to each other, this description should be understood to indicate that another component is not present between the two components.

In the descriptions herein below, terms such as "include" and "have" are intended to designate the presence of features, numerals, steps, operations, components, parts, and combinations thereof described herein, but should not be interpreted to exclude the presence or possible addition of one or more other features, numerals, steps, operations, components, parts, and combinations thereof.

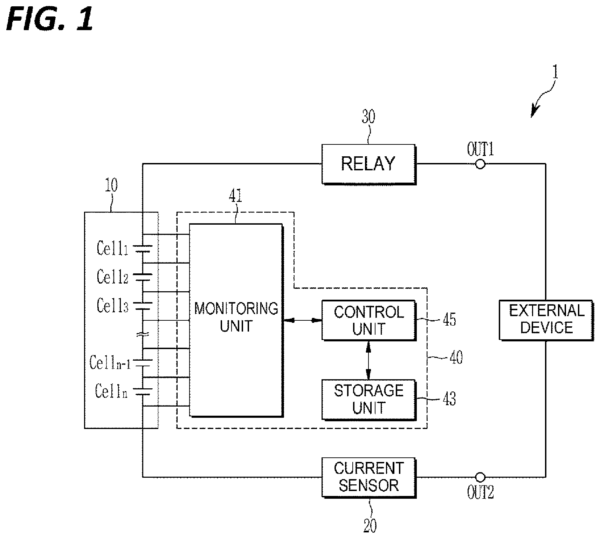

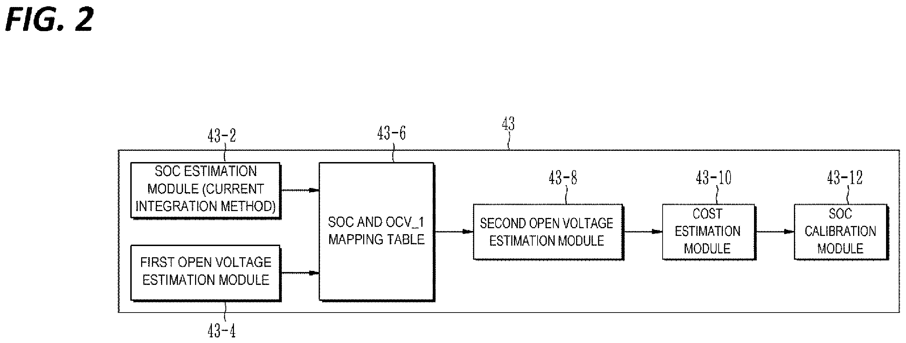

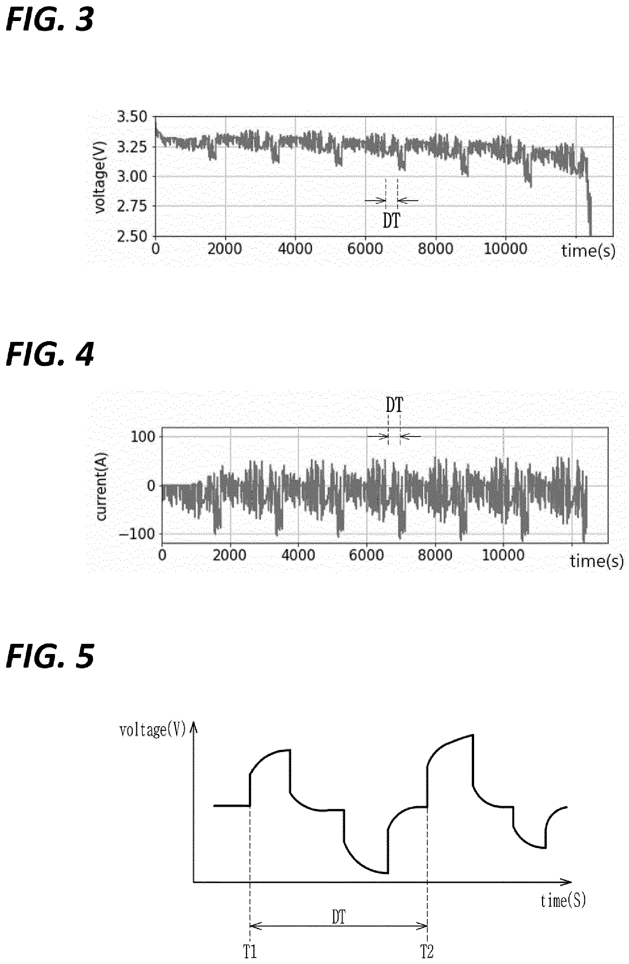

FIG. 1 is a block diagram illustrating a battery system according to an embodiment. FIG. 2 is a conceptual diagram illustrating a plurality of estimation modules and a mapping table stored in a storage unit of FIG. 1. FIG. 3 is a view illustrating an example of a graph corresponding to the cell voltage of a battery cell during an operation of an automobile system equipped with the battery system according to an embodiment. FIG. 4 is a view illustrating an example of a graph corresponding to the cell current of a battery cell during an operation of an automobile system equipped with the battery system according to an embodiment.

Referring to FIG. 1, a battery system 1 includes a battery 10, a current sensor 20, a relay 30, and a battery management system (hereinafter, referred to as a "BMS") 40.

The battery 10 may include a plurality of battery cells (Cell 1 to Celln) connected in series or parallel. In an embodiment, each battery cell may be a rechargeable secondary cell. A predetermined number of battery cells may be connected in series to form a battery module, a predetermined number of battery modules may be connected in series to form a battery pack, and a predetermined number of battery packs may be connected in parallel to form a battery bank, so that a required electric power may be supplied to an external device. FIG. 1 illustrates the battery 10 with the plurality of battery cells (Cell 1 to Celln) connected in series, but the present disclosure is not limited thereto. The battery 10 may be configured in the unit of a battery module, a battery pack, or a battery bank.

Each of the plurality of battery cells (Cell 1 to Celln) is electrically connected to the BMS 40 via a wire. The BMS 40 may collect and analyze various information on battery cells, including information on the plurality of battery cells (Cell1 to Celln), to control, for example, the charging, discharging, and protection operations of the battery cells, and may control the operation of the relay 30.

In FIG. 1, the battery 10 is connected between two output terminals (OUT1 and OUT2) of the battery system 1. The relay 30 is connected between the cathode (positive electrode) of the battery system 1 and the first output terminal (OUT1), and the current sensor 20 is connected between the anode (negative electrode) of the battery system 1 and the second output terminal (OUT2). The components and the connection relationship among the components illustrated in FIG. 1 are merely examples, and the present disclosure is not limited thereto. For example, the BMS 40 may be manufactured as a modularized chip, which may be wirelessly connected to each of the plurality of battery cells (Cell1 to Celln).

The current sensor 20 is connected in series in the current path between the battery 10 and the external device. The current sensor 20 may measure the battery current flowing in the battery 10, *i.e.,* the charging current and the discharging current, and transmit the measurement results to the BMS 40.

The relay 30 functions as a kind of switch for controlling the electrical connection between the battery system 1 and the external device. When the relay 30 is turned ON, the battery system 1 and the external device are electrically connected so that the charging or discharging is performed. When the relay 30 is turned OFF, the battery system 1 and the external device are electrically disconnected. At this time, the external device may be a charger in a charging cycle when the external device supplies a power to the battery to charge the battery 10, or a load in a discharging cycle when the battery 10 discharges a power to the external device.

The BMS 40 may include a monitoring unit 41, a storage unit 43, and a control unit 45.

The monitoring unit 41 is electrically connected to the cathode (positive electrode) and the anode (negative electrode) of each of the plurality of battery cells (Cell 1 to Celln), and measure the cell voltage, which is the voltage at both ends of each of the plurality of battery cells (Cell 1 to Celln). For example, FIG. 3 may be an example of a graph representing the cell voltage measured by the monitoring unit 41 for a time period from 0 seconds to about 12,200 seconds. For example, FIG. 3 may be a graph representing an average voltage of the plurality of battery cells. At an interval of a predetermined storage period (*e.g.*, every 0.1 % of ∆SOC), the monitoring unit 41 may transmit the cell voltage corresponding to a storage duration time DT (*e.g.,* 60 seconds) to the control unit 45. The storage duration time DT may correspond to a time period between adjacent storage periods.

The monitoring unit 41 may measure the cell voltage of each of the plurality of battery cells (Cell 1 to Celln) using various well-known methods, and calculate the cell current based on the measured cell voltage. For example, the cell current may be calculated using the average voltage of the cells described above and the resistance of the entire cells. Further, the monitoring unit 41 may measure the cell current of each of the plurality of battery cells (Cell 1 to Celln), using a current sensor (not illustrated) equipped in each battery cell. For example, FIG. 4 may be a graph representing the cell current calculated or measured by the monitoring unit 41 during a time period from 0 seconds to about 12,200 seconds. At the interval of the storage period, the monitoring unit 41 may transmit the cell current corresponding to the storage duration time DT to the control unit 45.

The storage unit 43 may store an SOC estimation module 43-2, a first open voltage estimation module 43-4, a mapping table 43-6, a second open voltage estimation module 43-8, a cost estimation module 43-10, and an SOC calibration module 43-12. At this time, a first open voltage OCV_1 and a second open voltage OCV_2 may each correspond to the open circuit voltage OCV. The plurality of estimation modules and the mapping table illustrated in FIG. 2 will be described in detail hereinafter with reference to FIGS. 5 to 9.

The control unit 45 may calibrate the initial SOC value of the battery 10 using the plurality of estimation modules 43-2, 43-4, 43-8, 43-10, and the SOC calibration module 43-12, and the mapping table 43-6 stored in the storage unit 43. Hereinafter, detailed descriptions will be made on how the control unit 45 calibrates the initial SOC value, with reference to FIGS. 5 to 10.

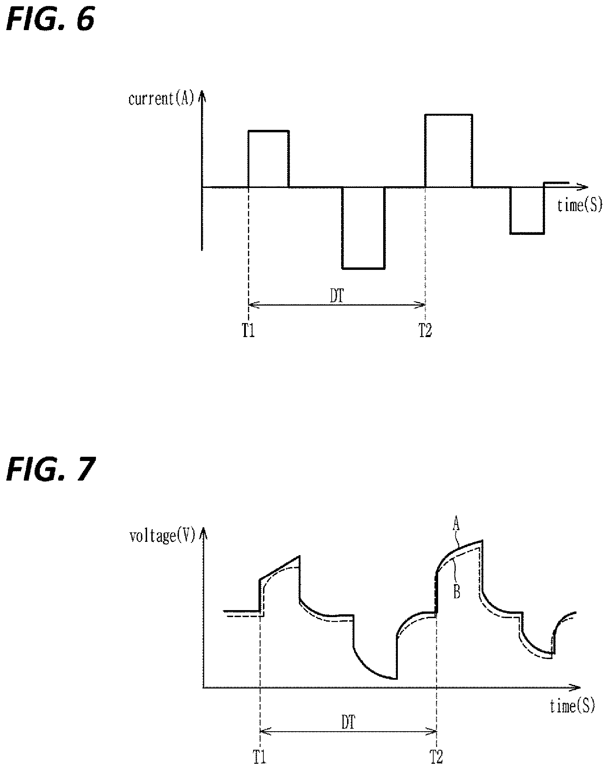

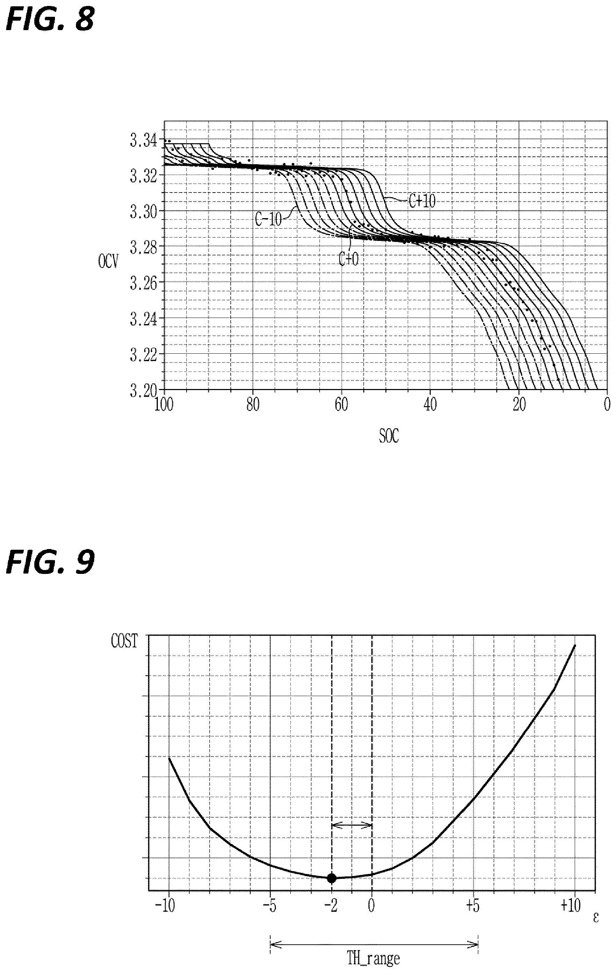

FIG. 5 is an enlarged view of a first cell voltage corresponding to the predetermined storage duration time DT illustrated in FIG. 3 *(e.g.,* voltages measured for 60 seconds). FIG. 6 is an enlarged view of a cell current corresponding to the predetermined storage duration time DT illustrated in FIG. 4 *(e.g.,* currents measured for 60 seconds). FIG. 7 is a graph representing the first cell voltage and a second cell voltage according to an embodiment. FIG. 8 is a view illustrating an example representing whether a first open voltage and a second open voltage match, according to an embodiment. FIG. 9 is a view illustrating another example representing whether the first open voltage and the second open voltage match, using the concept of the cost function according to an embodiment.

In the descriptions hereinafter, the cell voltage measured by the monitoring unit 41 will be referred to as the first cell voltage. The second cell voltage to be described later refers to a cell voltage calculated through an equivalent circuit model (ECM) based on the cell current measured by the monitoring unit 41. For example, each of the graphs of FIGS. 3 and 5 and a first graph A of FIG. 7 may correspond to the graph of the first cell voltage. A second graph B of FIG. 7 may correspond to the graph of the second cell voltage.

The SOC estimation module 43-2 may include an algorithm that estimates the SOC corresponding to a predetermined storage period by adding an integral value of the cell current for a predetermined time period to the initial SOC value of a battery cell. For example, the SOC estimation module 43-2 may include the algorithm of the Coulomb counting method, which is a well-known current integration method.

Referring to FIGS. 4 and 6, for example, when an N-th storage period T2 arrives, the control unit 45 may use the SOC estimation module 43-2 to integrate the cell current for the storage duration time DT and add the integral value of the cell current to the initial SOC value, thereby estimating the SOC corresponding to the arrival time of the N-th storage period T2. At this time, the storage duration time DT may correspond to the time period between two adjacent storage periods T1 and T2. The initial SOC value to which the integral value of the cell current is added may be the SOC corresponding to an N-1-th storage period T1.

The first open voltage estimation module 43-4 may estimate the first open voltage OCV_1 corresponding to the arrival time of a predetermined storage period T based on the profile of the cell current corresponding to the storage duration time DT. According to an embodiment, the control unit 45 may estimate the first opening voltage OCV_1 corresponding to the arrival time of the second storage period T2 based on the profile of the cell current corresponding to the storage duration time DT (=T2-T1).

For example, first, the first open voltage estimation module 43-4 may include the equivalent circuit model (ECM) that simulates the cell voltage corresponding to the cell current by using an equivalent circuit of a battery cell. For example, the ECM may be a model that includes three parameters to simulate the cell voltage of a battery cell. The three parameters may include the internal resistance R in the equivalent circuit, the open circuit voltage OCV, and a time constant "$\tau$" (tau) of a capacitor. The internal resistance R, the open circuit voltage OCV, and the time constant "$\tau$" of a capacitor may be variables that are derived through a fitting algorithm to be described later. For example, when the cell current is input to the ECM, the ECM may calculate an IR drop (Ohmic drop), thereby calculating the second cell voltage. However, without being limited to this type of ECM, the control unit 45 may generate the cell voltage corresponding to the cell current using various types of well-known ECMs. Further, the cell current and the second cell voltage may be, for example, the cell current profile and the second cell voltage profile that correspond to the storage duration time DT.

According to an embodiment, referring to FIGS. 6 and 7, the control unit 45 may generate a second cell voltage profile B (dashed line) of FIG. 7 that corresponds to the cell current profile of FIG. 6, by using the first open voltage estimation module 43-4. At this time, the first cell voltage profile illustrated in FIG. 5 may correspond to a first cell voltage profile A (solid line) of FIG. 7.

Next, referring to FIG. 7, the first open voltage estimation module 43-4 may include the fitting algorithm that fits the first cell voltage profile A and the second cell voltage profile B to each other to estimate the first open voltage OCV_1. By using the fitting algorithm, the control unit 45 may fit the second cell voltage profile B close to the first cell voltage profile A to derive the three parameters of the ECM, *i.e.,* including the internal resistance R, the open circuit voltage OCV, and the time constant "τ." That is, the control unit 45 may extract the open circuit voltage OCV, which is one of the three parameters, by using the fitting algorithm. According to an embodiment, the open circuit voltage OCV extracted through the fitting algorithm may be the first open voltage OCV_1.

The mapping table 43-6 may store mapping data in which the SOC estimated at the interval of a predetermined storage period and the first open voltage OCV_1 are mapped. Table 1 below is an example of the mapping table. For example, referring to FIGS. 5 and 6, when the N-th storage period T2 arrives, the control unit 45 may estimate the SOC through the current integration method by using the SOC estimation module 43-2, and simultaneously, calculate the first open voltage OCV_1 by using the first open voltage estimation module 43-4. The control unit 45 may map and store the SOC and the first open voltage OCV_1 that correspond to the arrival time of the N-th storage period T2, in the mapping table 43-6.

[Table 1]

| N | SOC | OCV_1 |
|---|-----|-------|
| 1 | 78.0 | 3.322 |
| 2 | 77.9 | 3.323 |
| 3 | 77.8 | 3.321 |
| 4 | 77.7 | 3.324 |
| … | … | … |
| n-3 | 18.1 | 3.238 |
| n-2 | 18.0 | 3.231 |
| n-1 | 17.9 | 3.219 |
| n | 17.8 | 3.222 |

When the predetermined calibration period arrives, the second open voltage (OCV_2) estimation module 43-8 may estimate a plurality of second open voltages OCV_2 corresponding to the SOCs stored in the storage unit 43 from a previous calibration period T_N-1 until the current calibration period T_N, based on the SOC_OCV graph or an SOC_OCV lookup table.

The calibration period may arrive when the storage period repeats the predetermined reference number of times. For example, the calibration period may be set to arrive when the SOC and the first open voltage OCV_1 are mapped and stored 100 times in the storage unit 43. Without being limited thereto, the arrival time of the calibration period may be set to various times such as when the storage period repeats 100 or more times or less than 100 times.

According to an embodiment, the second open voltage (OCV_2) estimation module 43-8 may calculate a first relationship graph, which is a graph of the relationship between the plurality of SOCs and the plurality of open circuit voltages stored during the calibration period, based on the lookup table. Further, the second open voltage (OCV_2) estimation module 43-8 may calculate a plurality of relationship graphs by reflecting a plurality of preset error values in the first relationship graph. The plurality of error values correspond to a plurality of input values to be discussed later.

According to another embodiment, the second open voltage (OCV_2) estimation module 43-8 may estimate a plurality of second open voltages corresponding to the plurality of SOCs stored during the calibration period, based on the lookup table. For example, it may be assumed that the calibration period arrives when the mapping data, in which the SOC and the first open voltage OCV_1 are mapped, are stored 100 times. The second open voltage (OCV_2) estimation module 43-8 may estimate 100 second open voltages OCV_2 corresponding to the 100 SOCs, respectively, based on the SOC_OCV lookup table.

The cost estimation module 43-10 may include an algorithm that calculates a final error value between the first open voltage OCV_1 and the second open voltage OCV_2, based on data accumulated for the time period from the previous calibration period T_N-1 until the current calibration period T_N. Referring to FIGS. 8 and 9, detailed descriptions will be made on how the control unit 45 calculates error values by using the cost estimation module.

In FIG. 8, a plurality of points may be the mapping data in which the plurality of SOCs and the plurality of first open voltages OCV_1 in Table 1 are mapped. That is, the number of points may correspond to the number of mapping data stored in Table 1.

The control unit 45 may calculate the plurality of second open voltages OCV_2 corresponding to the plurality of SOCs in the form of an SOC-OCV graph using the second open voltage estimation module 43-8. For example, in FIG. 8, a first SOC-OCV graph C+0 may be a graph generated by the control unit 45.

[Equation 1]

$$Cost = \sqrt{\sum_{K=1}^{n} \{OCV_K\_1 - OCV_K\_2(SOC_K - \varepsilon)\}^2}$$

Equation 1 may be an equation corresponding to the cost function used to derive a hypothesis function with the smallest error from an original value. Here, "n" is the total number of storage periods corresponding to the calibration period, "k" is a sequence number corresponding to a predetermined storage period, and input values "$\varepsilon$" may be set in a predetermined range ($\varepsilon\_min \leq \varepsilon \geq \varepsilon\_max$). For example, the minimum input value $\varepsilon\_min$ may be -10, and the maximum input value $\varepsilon\_max$ may be +10. For example, it is assumed that the input values "$\varepsilon$" are -10, -8, -6, -4, -2, 0, 2, 4, 6, 8, and 10.

According to an embodiment, the control unit 45 may calculate a summed value of straight-line distances between each of the plurality of relationship graphs and the plurality of mapping data. The control unit 45 may determine an error value corresponding to the minimum value among the plurality of summed values to be a final error value between the first and second open voltages. The final error value may correspond to the degree of discrepancy between the plurality of first open voltages and the plurality of second open voltages. Further, the final error value may correspond to the degree of discrepancy between the initial SOC value derived through the calculation and the actual initial SOC value. The unit of the error value may be %.

According to another embodiment, the control unit 45 may derive a plurality of costs corresponding to the plurality of input values ($\varepsilon$= -10, -8, -6, -4, -2, 0, 2, 4, 6, 8, 10), *i.e.,* the plurality of error values through Equation 1 above corresponding to the cost function. The control unit 45 may determine an error value corresponding to the lowest cost among the plurality of costs to be the final error value.

Each cost may correspond to the sum of the straight-line distances between each of the plurality of mapping data and a given SOC-OCV graph. For example, referring to Equation 1 and FIG. 9, as the cost is low, the matching rate between the plurality of mapping data and the SOC-OCV graph increases. In FIG. 9, when the input value "$\varepsilon$" is -2, the cost is lowest. The input value "$\varepsilon$" corresponding to the lowest cost may be determined to be the final error value. The unit of the final error value may be %. That is, for example, it may be estimated that the final error value in the given example is -2 %.

In FIG. 9, a reference range TH _range may be a range of allowable final error values between the first open voltage OCV_1 and the second open voltage OCV_2. For example, when the final error value falls within the reference range TH _range, the control unit 45 may determine that the error between the initial SOC value obtained through the calculation and the actual initial SOC value is small. Then, the control unit 45 may not calibrate the initial SOC value. In another example, when the final error value is out of the reference range, the control unit 45 may determine that the error between the initial SOC value obtained through the calculation and the actual initial SOC value is large. The SOC calibration module 43-12 may include an algorithm that calibrates the initial SOC value by adding the SOC corresponding to the final error value to the initial SOC value.

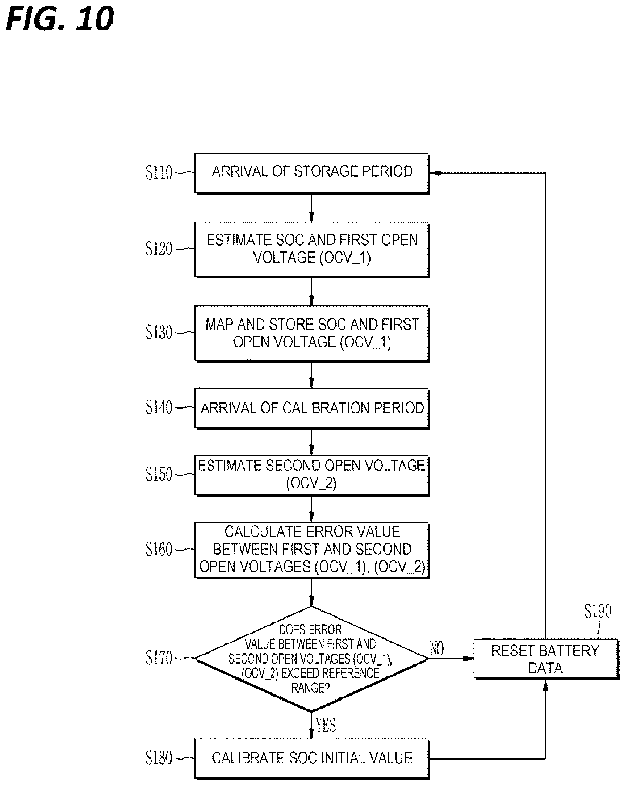

FIG. 10 is a flow chart illustrating the SOC calibration method according to an embodiment of the present disclosure.

Hereinafter, the SOC calibration method and the battery system for providing the method will be described in detail with reference to FIGS. 1 to 10.

Referring to FIG. 10, when a predetermined storage period arrives, the BMS 40 estimates the SOC of a battery cell and the first open voltage OCV_1 (S110, S120).

For example, the BMS 40 may calculate the cell current profile based on the cell current measured for the storage duration time DT. The BMS 40 may calculate the first cell voltage profile A based on the cell voltage measured at both ends of the battery cell for the storage duration time DT. The BMS 40 may store the cell current profile and the first cell voltage profile A in the storage unit 43.

The BMS 40 may add the integral value of the cell current for the storage duration time DT to the initial SOC value of the battery cell, to estimate the SOC of the battery cell corresponding to the storage period.

Referring to FIGS. 4 and 6, for example, when the N-th storage period T2 arrives, the BMS 40 integrates the magnitude of the cell current corresponding to the storage duration time DT. The BMS 40 may add the integral value of the cell current to the initial SOC value, thereby estimating the SOC corresponding to the arrival time of the N-th storage period T2. At this time, the storage duration time DT may correspond to the time period between the N-1-th storage period T1 and the N-th storage period T2. Further, the initial SOC value to which the integral value of the cell current is added may be the SOC corresponding to the N-1-th storage period T1.

Simultaneously, the BMS 40 may estimate the first open voltage OCV_1 of the battery cell that corresponds to the storage period, based on the equivalent circuit and the cell current of the battery cell. According to an embodiment, the BMS 40 may generate the second cell voltage profile B corresponding to the cell current profile for the storage duration time DT, through the equivalent circuit model (ECM) that simulates the cell voltage corresponding to the cell current using the equivalent circuit of the battery cell.

For example, the first cell voltage profile A indicated in the solid line in the example illustrated in FIG. 7 may be the voltage at both ends of the battery cell measured by the monitoring unit 41. Further, the second cell voltage profile B indicated in the dashed line may be the cell voltage profile calculated by the ECM, corresponding to the cell current profile.

Subsequently, the BMS 40 may fit the first cell voltage profile A and the second cell voltage profile B to each other, to estimate the first opening voltage OCV_1. For example, the BMS 40 may fit the second cell voltage profile B to the first cell voltage profile A by changing the three parameters that form the ECM, *i.e.,* the internal resistance R, the open circuit voltage OCV, and the time constant. The BMS 40 may derive the internal resistance R, the open circuit voltage OCV, and the time constant that make the second cell voltage profile B closest to the first cell voltage profile A. According to an embodiment, the open circuit voltage OCV derived when the second cell voltage profile B is closest to the first cell voltage profile A may correspond to the first open voltage OCV_1.

Next, the BMS 40 maps and stores the SOC and the first open voltage OCV_1 in the storage unit 43 (S130).

The BMS 40 may include the mapping table. For example, Table 1 described above may be an example of the mapping table. The mapping table may store the mapping data that map the SOC calculated by the current integration method at the interval of the storage period, and the first open voltage OCV_1 calculated simultaneously based on the equivalent circuit and the cell current of the battery cell.

Next, when the number of times the storage period arrives reaches a predetermined reference number of times so that the calibration period arrives, the BMS 40 estimates the plurality of second open voltages corresponding to the plurality of SOCs stored during the calibration period based on the SOC-open circuit voltage (OCV) lookup table (S140, S150).

The calibration period may arrive when the number of arrival times of the storage period reaches the predetermined reference number of times. For example, the calibration period may be set to arrive when the mapping data is stored 100 times in the storage unit 43. Without being limited thereto, the arrival time of the calibration period may be set to various times such as when the storage period repeats 100 or more times or less than 100 times.

According to an embodiment, the BMS 40 may calculate the first relationship graph, which is the graph of the relationship between the plurality of SOCs and the plurality of open circuit voltages stored during the calibration period based on the lookup table. Further, the BMS 40 may calculate the plurality of relationship graphs by reflecting the plurality of preset error values in the first relationship graph. The plurality of error values may correspond to the plurality of input values described below.

Referring to FIG. 8, the first SOC-OCV graph C+0 may correspond to the first relationship graph between the plurality of SOCs estimated during the calibration period and the plurality of second open voltages OCV_2 corresponding thereto. For example, the first SOC-OCV graph C+0 may be a graph corresponding to the input value ($\varepsilon$) "0." For possible prediction, the BMS 40 may calculate the plurality of relationship graphs by reflecting the plurality of preset input values in the first relationship graph. The BMS 40 may calculate a second SOC-OCV graph C-10 corresponding to the input value ($\varepsilon$) "-10." The BMS 40 may generate a third SOC-OCV graph C+10 corresponding to the input value ($\varepsilon$) "+10." That is, the BMS 40 may generate the plurality of SOC-OCV graphs, which are a plurality of relationship graphs corresponding to the plurality of input values ($\varepsilon$ = -10, -8, -6, -4, -2, 0, 2, 4, 6, 8, 10), respectively. For example, referring to FIG. 8, the input values "$\varepsilon$" may each correspond to the magnitude of the SOC for parallelizing the first relationship graph in the left-to-right direction. In FIG. 8, the plurality of black points may correspond to the plurality of first mapping data.

According to another embodiment, the BMS 40 may estimate the plurality of second open voltages corresponding to the plurality of SOCs stored during the calibration period, based on the lookup table.

Next, the BMS 40 calculates the final error value corresponding to the degree of discrepancy between the first open voltage OCV_1 and the second open voltage OCV_2 (S160), and determines whether the calculated final error value exceeds the predetermined reference range (TH_range) (S170).

According to an embodiment, the BMS 40 may calculate the summed value of the straight-line distances between each of the plurality of relationship graphs and the plurality of mapping data. The BMS 40 may determine an error value corresponding to the minimum value among the plurality of summed values, to be the final error value between the first and second open voltages. The final error value may correspond to the degree of discrepancy between the plurality of first open voltages and the plurality of second open voltages. Further, the final error value may correspond to the degree of discrepancy between the initial SOC value derived through the calculation and the actual initial SOC value. The unit of the error value may be %.

According to another embodiment, the BMS 40 may calculate the final error value based on a predetermined cost function that quantifies the degree of match between the plurality of first open voltages and the plurality of second open voltages. For example, the BMS 40 may derive the plurality of costs corresponding to the plurality of input values "ε," *i.e.,* the plurality of error values through Equation 1 above corresponding to the cost function. The BMS 40 may determine the error value corresponding to the lowest cost among the plurality of costs to be the final error value.

Referring to Equation 1 and FIG. 8, the summed value of the straight-line distances between the plurality of first mapping data and a predetermined SOC-OCV relationship graph may correspond to a cost. For example, the BMS 40 calculates the plurality of costs for the plurality of input values (ε= -10, -8, -6, -4, -2, 0, 2, 4, 6, 8, 10), respectively. The input value "ε" corresponding to the minimum cost among the plurality of calculated costs may correspond to the final error value. For example, referring to FIG. 9, it may be assumed that the cost is lowest when the input value "ε" is -2. Then, the BMS 40 may calculate -2 % as the final error value.

For example, for each of the plurality of input values (ε= -10, -8, -6, -4, -2, 0, 2, 4, 6, 8, 10), the BMS 40 may substitute the values of the plurality of SOCs, the values of the plurality of first open voltages OCV_1, and the values of the plurality of second open voltages OCV_2 into Equation 1 to calculate the plurality of costs. The plurality of costs calculated based on Equation 1 may correspond to the graph illustrated in FIG. 9.

Next, when it is determined that the final error value exceeds the reference range (S170, YES), the BMS 40 calibrates the initial SOC value (S180). Meanwhile, when it is determined that the final error value does not exceed the reference range (S170, NO), the BMS 40 does not calibrate the initial SOC value (S190).

The reference range TH _range may be the range of allowable final error values. Referring to FIG. 9, it may be assumed that the reference range TH _range corresponds to the range of -5 to +5.

For example, when the final error value calculated in S160 is +10 %, the BMS 40 may determine in S170 that the final error value of +10 % exceeds the reference range (TH_range) (S170, YES). In this case, in S180, the BMS 40 may calibrate the initial SOC value by adding the SOC corresponding to the final error value to the initial SOC value. For example, the BMS 40 may divide the SOC corresponding to the final error value by a preset time, and add the divided SOC to the initial SOC value in the unit of divided time, to calibrate the initial SOC value.

For example, it may be assumed that the final error value is +10 %, the initial SOC value is 50 %, and the preset time is 10 minutes. The BMS 40 may divide the SOC corresponding to the final error value of +10 % by 10 minutes, and add the divided SOC of 5 % (0.1×50 %=5 %) to the initial SOC value of 50 % in the unit of one minute for 10 minutes (e.g. 0.5%/min), so that the (SOC) initial value may be calibrated to 55 %.

Next, the BMS 40 deletes the plurality of mapping data stored in the storage unit 43, to reset the storage unit 43 (S190). Then, a new calibration period begins. That is, the entire process may repeat from S110 when the storage period arrives after the beginning of the new calibration period.

In another example, assuming that the final error value calculated in S160 is - 2 %, the BMS 40 may determine in S170 that the final error value of -2 % does not exceed the reference range TH_range (S170, NO). In this case, the BMS 40 resets the storage unit 43 by deleting the plurality of mapping data stored in the storage unit 43 without calibrating the initial SOC value (S190). Then, a new calibration period begins. That is, the entire process may repeat from S110 when the storage period arrives after the beginning of the new calibration period.

Meanwhile, according to an embodiment, the BMS 40 may calibrate the SOC only under a certain condition based on the error value of the estimated SOC. For example, after calculating the final error value in S160, the BMS 40 may determine whether a certain condition is satisfied, before determining in S170 whether the final error value calculated in S160 exceeds the reference range. For example, after calculating the final error value in S160, the BMS 40 may determine whether one or more of the following conditions are satisfied: (1) the number of accumulated data pairs is 100 or more; (2) the interval of cumulative SOC (ΔSOC) is in the range of 30 % or more; (3) the current SOC is 55 % or less, or (4) the open circuit voltage OCV is 30 mV or more. Then, only when one or more of the conditions above are satisfied, the BMS 40 may perform S170. In this way, the BMS 40 is configured to perform the calibration only when a certain condition is satisfied, so that unnecessary frequent calibrations may be prevented, and resources may be utilized for a more pressing purpose.

The determination of whether a certain condition is satisfied may not be performed only after S160, but may be performed in any step of the process, *e.g.,* after any of S120 to S150.

While the embodiments of the present disclosure have been described in detail, the protection scope of the present disclosure is not limited to the embodiments. Various modifications and improvements may be made by one of ordinary skill in the field of the present disclosure, and are also included in the protection scope of the present disclosure.

**Claims**

1. A battery system for estimating a state of charge (SOC) of a battery cell, the battery system comprising:

a storage configured to store, at each predetermined storage period, mapping data that map the SOC estimated based on an integral value of a cell current flowing in a battery cell, and a first open voltage estimated through a predetermined model that simulates a cell voltage corresponding to the cell current; and

a controller configured to perform a process including

when a number of times of storing the mapping data reaches a predetermined reference number of times so that a calibration period arrives, estimating a first relationship graph, which is a graph of a relationship between a plurality of SOCs and a plurality of open circuit voltages stored in the storage, based on a predetermined SOC-open circuit voltage lookup table,

calculating a plurality of relationship graphs by reflecting a plurality of preset error values in the first relationship graph,

calculating a summed value of distances between each of the plurality of relationship graphs and the mapping data,

determining an error value corresponding to a minimum value among a plurality of summed values to be a final error value between the first open voltage and a second open voltage, and

determining whether the final error value falls within a predetermined reference range, to determine whether to calibrate an initial SOC value.

2. The battery system according to claim 1, wherein when an N-th storage period arrives, the controller calculates the integral value by integrating the cell current measured for a storage duration time from an N-1-th storage period to the N-th storage period, and adds the integral value to the SOC corresponding to the N-1-th storage period, thereby calculating the SOC corresponding to the N-th storage period.

3. The battery system according to claim 1, wherein the storage stores a cell current profile calculated based on the cell current and a first cell voltage profile calculated based on a cell voltage, which is a voltage at both ends of the battery cell, for a storage duration time, which is a time period between adjacent storage periods, and

the controller generates a second cell voltage profile corresponding to the cell current profile through the model that includes an open circuit voltage as a parameter based on an equivalent circuit of the battery cell.

4. The battery system according to claim 3, wherein the controller calculates a magnitude of the open circuit voltage when the first and second cell voltage profiles are fitted closest to each other, as the first open voltage.

5. The battery system according to claim 1, wherein when the final error value is out of the predetermined reference range, the controller calibrates the initial SOC value by adding the SOC corresponding to the final error value to the initial SOC value.

6. The battery system according to claim 1, wherein when the final error value is out of the predetermined reference range, the controller divides the SOC corresponding to the final error value by a preset time, and adds the divided SOC to the initial SOC value in a unit of divided time, thereby calibrating the initial SOC value.

7. A battery system for estimating a state of charge of a battery cell, the battery system comprising:

a storage configured to store, at each predetermined storage period, mapping data that map a state of charge (SOC) estimated based on an integral value of a cell current flowing in a battery cell, and a first open voltage estimated through a predetermined model that simulates a cell voltage corresponding to the cell current; and

a controller configured to perform a process including

when a number of times of storing the mapping data reaches a predetermined reference number of times so that a calibration period arrives, estimating a plurality of second open voltages corresponding to a plurality of SOCs stored in the storage based on a predetermined SOC-open circuit voltage lookup table,

calculating a final error value corresponding to a degree of discrepancy between a plurality of first open voltages stored in the storage and the plurality of second open voltages based on a predetermined cost function that quantifies a degree of matching between the plurality of first open voltages and the plurality of second open voltages, and

determining whether the final error value falls within a predetermined reference range, to determine whether to calibrate an initial SOC value.

8. The battery system according to claim 7, wherein the controller determines an error value corresponding to a smallest cost among a plurality of costs derived through an equation below corresponding to the cost function, to be the final error value,

Equation 1

$$Cost = \sqrt{\sum_{K=1}^{n} \{OCV_{K\_}1 - OCV_{K\_}2(SOC_K - \varepsilon )\}^2}$$

wherein Cost is a cost, OCV_1 is a first open voltage, OCV_2 is a second open voltage, SOC is a state of charge, "k" is a storage period count, "n" is the reference number of times, and "$\varepsilon$" is an error value, which corresponds to each of a plurality of integers that falls within a predetermined range.

9. The battery system according to claim 7, wherein when an N-th storage period arrives, the controller calculates the integral value by integrating the cell current measured for a time period from an N-1-th storage period to the N-th storage period, and adds the integral value to the SOC corresponding to the N-1-th storage period, thereby calculating the SOC corresponding to the N-th storage period.

10. The battery system according to claim 7, wherein the storage stores a cell current profile calculated based on the cell current and a first cell voltage profile calculated based on a cell voltage, which is a voltage at both ends of the battery cell, for a storage duration time, which is a time period between adjacent storage periods, and the controller generates a second cell voltage profile corresponding to the cell current profile through the model that includes an open circuit voltage as a parameter based on an equivalent circuit of the battery cell.

11. The battery system according to claim 10, wherein the controller calculates a magnitude of the open circuit voltage when the first and second cell voltage profiles are fitted closest to each other, as the first open voltage.

12. The battery system according to claim 7, wherein when the final error value is out of the predetermined reference range, the controller calibrates the initial SOC value by adding the SOC corresponding to the final error value to the initial SOC value.

13. The battery system according to claim 7, wherein when the final error value is out of the predetermined reference range, the controller divides the SOC corresponding to the final error value by a preset time, and adds the divided SOC to the initial SOC value in a unit of divided time, thereby calibrating the initial SOC value.

14. A method of calibrating a state of charge, the method comprising:

when a predetermined storage period arrives, estimating a state of charge (SOC) of a battery cell and a first open voltage based on an integral value of a cell current flowing in the battery cell and a predetermined model that simulates a cell voltage corresponding to the cell current, respectively;
storing mapping data that map the SOC and the first open voltage in a storage;
when a number of times of storing the mapping data reaches a predetermined reference number of times so that a calibration period arrives, estimating a plurality of second open voltages corresponding to a plurality of SOCs stored in the storage based on a predetermined SOC-open circuit voltage lookup table;
calculating a final error value corresponding to a degree of discrepancy between a plurality of first open voltages stored in the storage and the plurality of second open voltages based on a predetermined cost function that quantifies a degree of matching between the plurality of first open voltages and the plurality of second open voltages;
determining whether the final error value falls within a predetermined reference range; and
when determined that the final error value is out of the predetermined reference range, calibrating an initial SOC value.

15. The method according to claim 14, wherein the calculating the final error value includes

determining an error value corresponding to a smallest cost among a plurality of costs derived through an equation below corresponding to the cost function, to be the final error value,

Equation 1

$$Cost = \sqrt{\sum_{K=1}^{n} \{OCV_K\_1 - OCV_K\_2(SOC_K - \varepsilon)\}^2}$$

wherein Cost is a cost, OCV_1 is a first open voltage, OCV_2 is a second open voltage, SOC is a state of charge, "k" is a storage period count, "n" is the reference number of times, and "ε" is an error value, which corresponds to each of a plurality of integers that falls within a predetermined range.

16. The method according to claim 14, wherein the estimating the SOC and the first open voltage includes

storing a cell current profile calculated based on the cell current and a first cell voltage profile calculated based on a cell voltage, which is a voltage at both ends of the battery cell, for a storage duration time, which is a time period between adjacent storage periods, and
generating a second cell voltage profile corresponding to the cell current profile through the model that includes an open circuit voltage as a parameter based on an equivalent circuit of the battery cell, and
calculating a magnitude of the open circuit voltage when the first and second cell voltage profiles are fitted closest to each other, as the first open voltage.

17. The method according to claim 14, wherein the calibrating the initial SOC value includes
adding the SOC corresponding to the final error value to the initial SOC value, thereby calibrating the initial SOC value.

18. The method according to claim 14, wherein the calibrating the initial SOC value includes
dividing the SOC corresponding to the final error value by a preset time, and adding the divided SOC to the initial SOC value in a unit of divided time, thereby calibrating the initial SOC value.

# FIG. 1

EP 4 585 946 A1

**FIG. 2**

43-2 · SOC ESTIMATION MODULE (CURRENT INTEGRATION METHOD)

43-4 · FIRST OPEN VOLTAGE ESTIMATION MODULE

43-6 · SOC AND OCV_1 MAPPING TABLE

43-8 · SECOND OPEN VOLTAGE ESTIMATION MODULE

43-10 · COST ESTIMATION MODULE

43-12 · SOC CALIBRATION MODULE

43

# FIG. 3

# FIG. 4

# FIG. 5

## FIG. 6

## FIG. 7

## FIG. 8

## FIG. 9

## FIG. 10

S110 — ARRIVAL OF STORAGE PERIOD

S120 — ESTIMATE SOC AND FIRST OPEN VOLTAGE (OCV_1)

S130 — MAP AND STORE SOC AND FIRST OPEN VOLTAGE (OCV_1)

S140 — ARRIVAL OF CALIBRATION PERIOD

S150 — ESTIMATE SECOND OPEN VOLTAGE (OCV_2)

S160 — CALCULATE ERROR VALUE BETWEEN FIRST AND SECOND OPEN VOLTAGES (OCV_1), (OCV_2)

S170 — DOES ERROR VALUE BETWEEN FIRST AND SECOND OPEN VOLTAGES (OCV_1), (OCV_2) EXCEED REFERENCE RANGE?

NO → S190 RESET BATTERY DATA

YES

S180 — CALIBRATE SOC INITIAL VALUE

| INTERNATIONAL SEARCH REPORT | International application No. |
|---|---|
| | **PCT/KR2024/005490** |

| A. | CLASSIFICATION OF SUBJECT MATTER |
|---|---|

**G01R 31/3828**(2019.01)i; **G01R 31/396**(2019.01)i; **G01R 31/367**(2019.01)i; **G01R 31/385**(2019.01)i; **G01R 31/374**(2019.01)i; **G01R 19/165**(2006.01)i; **G01R 35/00**(2006.01)i; **H02J 7/00**(2006.01)i

According to International Patent Classification (IPC) or to both national classification and IPC

| B. | FIELDS SEARCHED |
|---|---|

Minimum documentation searched (classification system followed by classification symbols)

G01R 31/3828(2019.01); G01R 19/165(2006.01); G01R 31/36(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충전상태(state of charge), 개방 전압(open circuit voltage), 매핑(mapping), 오차값(error value), 교정(correct)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2012-0082965 A (KIM, Deuk Soo) 25 July 2012 (2012-07-25)<br>See paragraphs [0023]-[0024] and claims 1-2. | 1-18 |
| A | KR 10-2008-0000160 A (SAMSUNG SDI CO., LTD.) 02 January 2008 (2008-01-02)<br>See paragraphs [0087]-[0088] and claims 1-4. | 1-18 |
| A | JP 2014-202551 A (GS YUASA CORP.) 27 October 2014 (2014-10-27)<br>See claims 1-5 and figures 1-12. | 1-18 |
| A | KR 10-2014-0062772 A (HYUNDAI MOBIS CO., LTD.) 26 May 2014 (2014-05-26)<br>See paragraphs [0026]-[0041] and figures 1-3. | 1-18 |
| A | JP 2010-271288 A (MITSUBISHI HEAVY IND., LTD. et al.) 02 December 2010 (2010-12-02)<br>See claims 1-5 and figures 1-2. | 1-18 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **05 August 2024** | **07 August 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/005490**

| Patent document cited in search report | | | Publication date (day/month/year) | Patent family member(s) | | | Publication date (day/month/year) |
|---|---|---|---|---|---|---|---|
| KR | 10-2012-0082965 | A | 25 July 2012 | KR | 10-1238478 | B1 | 04 March 2013 |
| KR | 10-2008-0000160 | A | 02 January 2008 | CN | 100547849 | C | 07 October 2009 |
| | | | | CN | 101098029 | A | 02 January 2008 |
| | | | | DE | 602007008793 | D1 | 14 October 2010 |
| | | | | EP | 1873542 | A1 | 02 January 2008 |
| | | | | EP | 1873542 | B1 | 01 September 2010 |
| | | | | JP | 2008-010420 | A | 17 January 2008 |
| | | | | JP | 5074830 | B2 | 14 November 2012 |
| | | | | US | 2007-0299620 | A1 | 27 December 2007 |
| | | | | US | 8008891 | B2 | 30 August 2011 |
| JP | 2014-202551 | A | 27 October 2014 | CN | 104101840 | A | 15 October 2014 |
| | | | | CN | 104101840 | B | 22 June 2018 |
| | | | | EP | 2787361 | A1 | 08 October 2014 |
| | | | | EP | 2787361 | B1 | 21 November 2018 |
| | | | | JP | 6155774 | B2 | 05 July 2017 |
| | | | | US | 2014-0303914 | A1 | 09 October 2014 |
| | | | | US | 9983270 | B2 | 29 May 2018 |
| KR | 10-2014-0062772 | A | 26 May 2014 | CN | 103823184 | A | 28 May 2014 |
| | | | | CN | 103823184 | B | 20 October 2017 |
| | | | | KR | 10-1960090 | B1 | 19 March 2019 |
| JP | 2010-271288 | A | 02 December 2010 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230079004